# EUROPEAN PATENT SPECIFICATION

(11) **EP 2 729 518 B1**
(45) Date of publication and mention of the grant of the patent: **11.09.2019**
(21) Application number: 11731314.8
(22) Date of filing: 05.07.2011
(51) Int. Cl.: C08J 3/28

(54) **METHOD FOR PROCESSING A FLEXIBLE SUBSTRATE**
VERFAHREN ZUR VERARBEITUNG EINES FLEXIBLEN SUBSTRATS
PROCÉDÉ POUR LE TRAITEMENT D'UN SUBSTRAT SOUPLE

(43) Date of publication of application: 14.05.2014
(73) Proprietor: Applied Materials, Inc., Santa Clara, CA 95054 (US)
(72) Inventor: KLEMM, Günter, 63667 Nidda (DE); HOFFMANN, Gerd, 63486 Bruchköbel (DE); LOTZ, Hans-Georg, 63584 Gründau-Rothenbergen (DE); WOLFF, Alexander, 63755 Alzenau (DE)
(74) Representative: Zimmermann & Partner Patentanwälte mbB
(86) International application number: PCT/EP2011/061330
(87) International publication number: WO 2013/004301

(56) References cited:
- EP-A1- 1 148 381
- WO-A1-2004/101662
- US-A- 4 803 126
- US-A1- 2007 292 567
- LEONHARDT D ET AL: "Plasma enhanced surface treatments using electron beam-generated plasmas", SURFACE AND COATINGS TECHNOLOGY, ELSEVIER, AMSTERDAM, NL, vol. 188-189, 1 November 2004 (2004-11-01) , pages 299-306, XP004622225, ISSN: 0257-8972, DOI: 10.1016/J.SURFCOAT.2004.08.195
- BURKERT S ET AL: "Tuning of surface properties of thin polymer films by electron beam treatment", APPLIED SURFACE SCIENCE, ELSEVIER, AMSTERDAM, NL, vol. 255, no. 12, 1 April 2009 (2009-04-01), pages 6256-6261, XP026011666, ISSN: 0169-4332, DOI: 10.1016/J.APSUSC.2009.01.096 [retrieved on 2009-02-11]
- Y. Nakayama ET AL: "Surface Analysis of Plasma-Treated Poly(ethylene terephthalate) Film", Polymer Engineering and Science, Vol 31, No 11, 1 June 1991 (1991-06-01), pages 812-817, XP55020108, Retrieved from the Internet: URL:http://onlinelibrary.wiley.com/store/1 0.1002/pen.760311108/asset/760311108_ftp.p df?v=1&t=gyzl8r5n&s=0e070f8c8ad1f5f882bc19 ddb85ecc8143cafdea [retrieved on 2012-02-23]
- Terhi Hirvikopi ET AL: "Thin Inorganic Barrier Coatings for Packaging Materials", 2010 Place Conference; April 18-21, 2010; Albuquerque, New Mexico, USA, 18 April 2010 (2010-04-18), pages 1-41, XP55020112, Retrieved from the Internet: URL:http://www.tappi.org/content/events/10 PLACE/papers/hirvikorpi.pdf [retrieved on 2012-02-23]
- E. Amendola ET AL: "A Study of Adhesion of Silicon Dioxide on Polymeric Substrates for Optoelectronic Applications", , 11 April 2011 (2011-04-11), pages 1-18, XP55020114, Retrieved from the Internet: URL:http://www.intechopen.com/source/pdfs/ 15233/InTech-A_study_of_adhesion_of_silico n_dioxide_on_polymeric_substrates_for_opto electronic_applications.pdf [retrieved on 2012-02-23]

## Description

### TECHNICAL FIELD

Embodiments of the present disclosure relate to methods for processing a flexible substrate. Particularly, they relate to methods for the pre-treatment of flexible substrates before coating to improve the barrier properties of the coated substrate.

### BACKGROUND ART

Processing of flexible substrates, such as plastic films or foils, is in high demand in the packaging industry, semiconductor industries and other industries. Processing often consists of coating a flexible substrate with a desired material. For example, various processes for treating substrates are disclosed in the following documents: Leonhardt et al.: Plasma enhanced surface treatments using electron-beam generated plasmas, Surface and Coatings Technology; Burkert et al.: Tuning of surface properties of thin film polymer films by electron beam treatment, Applied Surface Science; Nakayama et al.: Surface Analysis of Plasma-Treated Poly(ethylene terephthalate*;* Terhi Hirvikopi et al.: Thin Inorganic Barrier Coatings for Packaging Materials, Conference Paper, 2010 Place Conference, Albuquerque, New Mexico; Amendola et al.: A Study of Adhesion of Silicon Dioxide on Polymeric Substrates for Optoelectronic Applications, Optoelectronic Devices and Properties*;* EP 1 148 381 A1; WO 2004/101662 A1; US 4,803,126 A; and US 2007/292567 A1.

Systems performing this task generally include a processing drum, e.g., a cylindrical roller, coupled to a processing system for transporting the substrate and on which at least a portion of the substrate is processed. For example, a portion of a flexible substrate may be coated on the processing drum while the substrate is being transported.

Plastic films for food packing can be coated with metal or silicon containing layers to protect the food inside the packaging against oxygen and water vapor permeating through the plastic material, which might otherwise lead to deterioration of the packed goods. Thereby, the barrier properties of the coated plastic substrate depend on a variety of factors, e.g., the plastic material itself, the thickness and nature of the coating, and various process parameters during the coating process. While some parameters may improve water vapor or oxygen barrier properties, they may have adverse effects on other aspects with respect to overall substrate quality.

Accordingly, it is desirable to have a method for generally improving the barrier properties of coatings on plastic substrates.

### SUMMARY OF THE INVENTION

In one aspect, a method of processing a flexible substrate is provided. The method includes providing a flexible substrate having a polymerized surface; emitting an electron beam; exposing the polymerized surface to the electron beam by directing the electron beam onto the polymerized surface, and wherein the electron beam has an electron beam energy from 1 to 6 keV; modifying the polymerized surface by the exposure to the electron beam; and depositing a barrier layer on the modified surface.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.
Fig. 1 is a schematic view of an exemplary system for processing a flexible substrate according to embodiments.
Fig. 2 is a schematic perspective view of a processing drum of the embodiments shown in Fig. 1.
Fig. 3 is a schematic view of a system for processing a flexible substrate according to further embodiments.
Fig. 4 is a flow chart illustrating an exemplary method for processing a flexible substrate according to embodiments.

### DETAILED DESCRIPTION OF THE INVENTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Embodiments disclosed herein relate to a method of treating a plastic substrate with an electron beam prior to coating the film with a silicon, silicon oxide, metal, metal oxide or metal nitride layer, as an example, aluminum, aluminum oxide or aluminum nitride. The inventors have found out that the pretreatment with electrons unexpectedly improves the barrier properties of the films after coating, when compared to the same film with an identical coating, but without an electron treatment before coating. Thereby, the side of the film treated with the electrons is typically, but not limited to, the side which is directed away from a subsequent processing roll, and which is subsequently covered with a coating.

It is assumed that the perceived effect is a combination of various partial effects of the electron treatment: By directing the electron beam on the polymer substrate, the surface roughness of the substrate is decreased. Further, the electron structure of the film surface is altered by the impacting electrons, e.g. excited, such that the adhesion between the plastic film surface and the subsequently applied coating is changed with the result of improved barrier properties against water vapor and oxygen. Furthermore, bonds in the surface of the polymer film are broken up, such that the nature of the bonding between a subsequent coating and the film is altered, respectively improved.

The nature of at least a part of the effects described above is such that the surface of the plastic film is structurally modified, respectively irreversibly modified. Further, the amount of dissociated water or water molecules on the surface is decreased, hence the surface is cleaned by the electron beam. It is to be noted that the substrates described herein are typically already completely polymerized, i.e., the electron beam does not contribute to promote a polymerization reaction on the surface and/or the substrate is typically already cured previously to being treated by the electron beam.

In embodiments, the pre-treatment with the electron beam may be combined with the application of a gas to the space above the plastic film, wherein the gas molecules are excited respectively ionized by the electron beam. Suitable gases have shown to be Ar or, more particularly, helium or reactive gases like N₂, O₂, or a mixture of any of the former.

Within the following description of the drawings, the same reference numbers refer to the same components. Generally, only the differences with respect to the individual embodiments are described.

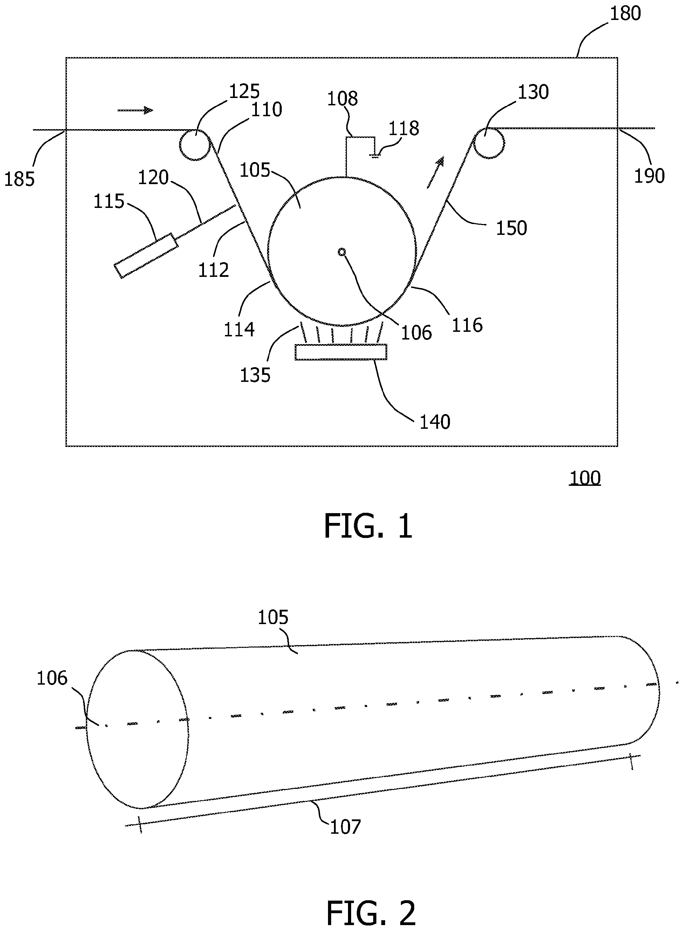

Fig. 1 shows an exemplary system 100 for processing a flexible plastic substrate 110, such as, but not limited to, a web, a film, or a foil. The exemplary embodiment includes a vacuum chamber 180. According to embodiments, processing of the flexible substrate is performed within vacuum chamber 180. In particular, a processing drum 105 is disposed in vacuum chamber 180 of exemplary system 100. Thereby, processing may be performed under vacuum conditions. Vacuum chamber 180 is typically provided with an entrance 185 adapted for facilitating the introduction of substrate 110 into the chamber while a vacuum condition is maintained therein, and with an exit 190 for the processed substrate 150. Alternatively, the entire roll-to-roll system, including unwinding and winding rollers (not shown in Fig. 1), may be contained in vacuum chamber 180.

According to embodiments herein, system 100 includes a first roller 125 adapted for transporting and/or laterally stretching flexible substrate 110. In particular, according to embodiments herein, first roller 125 is configured, e.g., disposed relative to processing drum 105, in a manner such that flexible substrate 110 is laterally stretched (i.e., stretched along the substrate width). Thereby, an appropriate transport of flexible substrate 110 onto processing drum 105 is facilitated.

According to embodiments, first roller 125 is disposed adjacently to processing drum 105, i.e., without any other roller in the substrate transport path extending between first roller 125 and processing drum 105. According to embodiments, first roller 125 is a guiding roller. According to certain embodiments, as in exemplary system 100, first roller 125 is disposed within vacuum chamber 180. Alternatively, first roller 125 may be disposed outside of vacuum chamber 180. First roller 125 may have, for example, but not limited to, a cylindrical shape.

According to embodiments herein, processing drum 105 is rotatable with respect to a longitudinal axis thereof. Thereby, flexible substrate 110 may be transported and processed by being moved over a rotating processing drum 105. According to embodiments, the longitudinal axis 106 corresponds to the center axis of processing drum 105. According to embodiments, processing drum 105 has a processing drum length 107 along longitudinal axis 106, such as shown in Fig. 2.

According to embodiments herein, the flexible substrate is spooled from a roll (not shown) prior to being provided to roller 125. The coated substrate 150 is typically guided over roller 130 to an exit out of the vacuum chamber 180, and the flexible substrate is typically spooled onto a roll (not shown) after being processed in vacuum chamber 180, or after further processing steps in the same or a further vacuum chamber.

According to embodiments, the processing drum length 107 is of at least 105% of the width of substrate 110. According to embodiments, the coating of flexible substrate 110 is affected over processing drum 105, for example, but not limited thereto, by performing coating on a portion of flexible substrate 110 over processing drum 105.

According to embodiments, an electron beam 120 is directed onto a surface 112 of substrate 110 prior to coating the substrate. The beam 120 is typically directed onto surface 112 between roller 125 and processing drum 105, more specifically to the area 114 of the drum at which the substrate gets into contact with processing drum 105. It should be noted that first area 114 is an area considered relative to vacuum chamber 180, i.e., a typically stationary element during processing of flexible substrate 110. That is, as used herein, first area 114 is not an area that rotates with processing drum 105. Electron beam device 115 emitting the electron beam 120 is adapted such that the electron beam affects the substrate across its entire width, such that due to the longitudinal movement of the substrate 110, the whole surface (on one side) of the substrate passing through vacuum chamber 180 is treated with the electron beam 120. Electron beam device 115 may for example be an electron source such as an electron flood gun, a linear electron gun, an electron beam, or the like. The gas used in the electron source may be Argon, O₂, N₂, CO₂, or He, more particularly O₂, N₂, CO₂, or He.

Thereby, it is emphasized that the polymerized surface 112 treated with the emitted electrons is physically, respectively structurally altered in order to achieve the improved barrier properties of the subsequently coated substrate. The desired effect can be achieved by providing electrons at energies from 1 keV to 6 keV, more typically from 1 keV to 4 keV, for example, 2 keV, 3 keV, or 4keV. Typical electron currents are from 20 mA to 1500 mA, for example 500 mA.

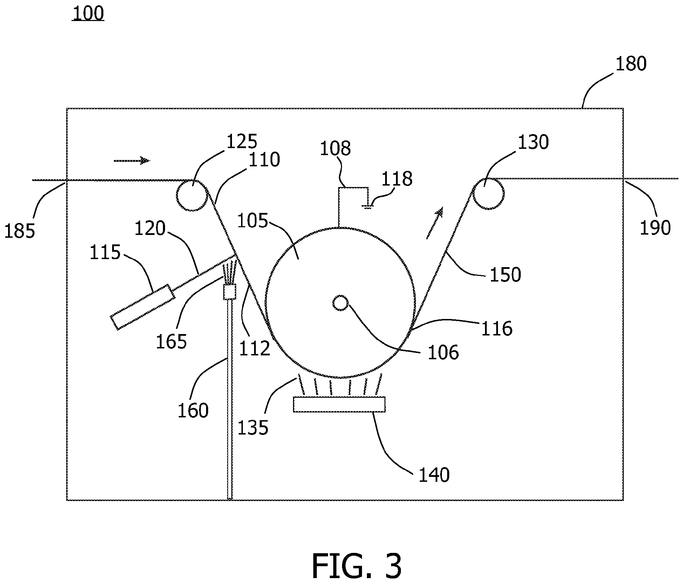

According to embodiments, electron beam device 115 affects the flexible substrate 110 prior to further processing thereof. Thereby, the modification of the substrate surface 112 of substrate 110 also may provide a potential difference between flexible substrate 110 and processing drum 105. In particular, electron beam device 115 may charge flexible substrate 110 by providing electrons thereon. Thereby, a negative charge can be applied to the flexible substrate. If processing drum 105 is grounded, as exemplarily indicated by ground connection 108 of processing drum 105 to ground 118 (shown in Fig. 1 and 3) the charge on flexible substrate 110 provides the potential difference to the grounded processing drum 105. However, the charging effect is only to be seen as a by-product of the method as disclosed herein. It does typically not contribute to the physical/structural alterations of the substrate surface 112 described above, and thus also does not contribute to the improvement of the barrier properties according to embodiments.

According to embodiments, electron beam device 115 is configured to simultaneously affect the flexible substrate 110 along a line extending across a substantial portion of the width of the flexible substrate. In particular, electron beam device 115 may be a linear source, i.e., a source simultaneously emitting charged particles along an elongated area, such as a linear electron source. For example, electron beam device 115 may emit electrons simultaneously over an approximately rectangular area with a longer length of about the substrate width or, more particularly, at least 95% of the substrate width, and a shorter length between 0,5 to 10 % of the substrate width. The distance of an opening of the electron beam device 115 from the substrate surface may be from 5 mm to 120 mm, more typically from 20 mm to 100 mm.

A linear source of charged particles may facilitate a fast processing of the flexible substrate, so that transport speed of the substrate can be maximized. According to alternative embodiments, electron beam device 115 is a scanning source of electrons, i.e., a source emitting electrons and scanning the emission direction along a line or region, such as area 114 shown in Fig. 1, typically along the entire substrate width. Accordingly, it is understood that the term "electron beam" as used herein is not limited to a beam which is focused on a spot, but also includes a beam scanned respectively swept over a line or an area, as well as a plurality of electrons emitted from a larger area in the direction of target area on the substrate, hence a volume stream of electrons. Examples of a linear electron source are described in EP patent application EP 2073243 A1, entitled "Linear electron source, evaporator using linear electron source, and applications of electron sources" filed December 21, 2007, which is incorporated herein by reference to the extent the applications are not inconsistent with this disclosure. Therein, it is referred to a linear plasma electron source including a housing acting as a first electrode, the housing having side walls; a slit opening in the housing for passing of an electron beam, the slit opening defining a length direction of the source; a second electrode being arranged within the housing and having a first side facing the slit opening, the first side being spaced from the slit opening by a first distance, wherein the length of the electron source in the length direction is at least 5 times the first distance and is at least 70 cm; and at least one gas supply for providing a gas into the housing, wherein the first electrode is the anode and the second electrode is the cathode.

According to embodiments, a flexible substrate includes, but is not limited to a polypropylene-containing substrate, a polyester substrate, a nylon substrate, an OPP substrate (i.e., an oriented polypropylene film), and a CPP substrate (i.e., a casting polypropylene film). According to embodiments, the flexible substrate has a thickness below 50 µm or, more specifically, 5 µm or, even more specifically 2 µm. For example, the flexible substrate may be an OPP substrate, e.g. with a thickness of 50 µm or below, such as 20 µm. Embodiments described herein also contemplates that the flexible substrate is an ultra thin film having a thickness of 2 µm or below, e.g., 0.7 µm.

According to embodiments, system 100 includes a coating unit 140 disposed facing processing drum 105 for coating at least a portion of flexible substrate 110 on processing drum 105. According to embodiments, coating unit 140 is disposed for coating a portion of flexible substrate 110, which is downstream of first area 114 and upstream of second area 116, where the coated substrate 150 is guided away from processing drum 105 by roller 130.

Coating unit 140 is provided for coating flexible substrate 110 with a film of a coating material 135, so that a flexible coated substrate 150 is manufactured. According to different embodiments, which can be combined with any of the embodiments described herein, the coating can be achieved by thermal evaporation, an electron beam evaporation, a sputtering process, CVD processes, plasma enhanced processes, or combinations thereof. Coating unit 140 may consist, for example, of a staggered boat evaporator for facilitating an improved uniformity of the coated layer.

According to embodiments, coating unit 140 is configured for coating flexible substrate 110 with a metal, metal oxide, or metal nitride layer. For example, coating unit 140 may be configured to coat flexible substrate 110 with an aluminum layer. The coated metal layer typically has a thickness of less than 500 nm or, more specifically, less than 450 nm or, even more specifically, less than 100 nm. Furthermore, according to embodiments, the coated metal layer has a thickness of at least 5 nm or, more specifically, of at least 8 nm or, even more specifically, of at least 10 nm. For example, but not limited to, flexible substrate 110 may be coated with an aluminum layer with a thickness ranging from about 10 nm to 100 nm or with an aluminum oxide (AlOₓ) or aluminum nitride layer with a thickness ranging from about 8 nm to 450 nm. In some cases, such as with AlOₓ, the coating may be optically transparent. In embodiments, substrate 110 is coated with a silicon layer or silicon oxide layer.

According to embodiments, the barrier properties of the coated substrate 150 with respect to water vapor and/or oxygen are further improved by additionally exciting a processing gas with the emitted electron beam before the electron beam affects the substrate surface 112. To this end, a processing gas is introduced into the vacuum chamber 180 at a position or region where it can interact with the electron beam 120 in the vicinity of the substrate surface 112. A gas inlet 160 is schematically shown in Fig. 3, wherein the gas 165 is directed to an area close to the surface 112 of substrate 110. After the gas molecules have interacted with the electron beam 120, they interact with the substrate surface. Thereby, the surface is exposed to the excited processing gas. Suitable processing gases have shown to be argon, helium, a mixture of reactive gases such as a mixture of nitrogen and oxygen; and combinations of any of the former, more particularly nitrogen and oxygen, helium, and mixtures thereof. If an excited processing gas is employed, electron energies from about 1 keV to 6 keV are suitable to yield a sufficient excitation of the gas, more particularly 1 to 4 keV.

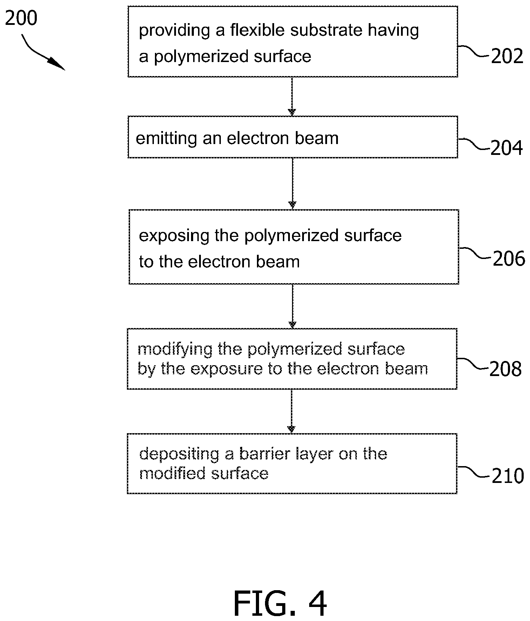

Fig. 4 schematically shows a method 200 of processing a flexible substrate according to embodiments. The method includes providing a flexible substrate having a polymerized surface in 202, emitting an electron beam in 204, exposing the polymerized surface to the electron beam in 206 by directing the electron beam onto the polymerized surface, wherein the electron beam has an electron energy from 1 to 6 keV, modifying the polymerized surface by the exposure to the electron beam in 208; and depositing a barrier layer on the modified surface in 210.

In embodiments, on the substrate surface 112 modified by the electron beam, a further layer is applied to the substrate 110 prior to the coating of the barrier layer of a metal, a metal oxide, silicon, or a silicon oxide. The further layer may include AlOₓ, or an organic layer like Triacine or Acrylate. Additionally or alternatively, a further layer may be applied on top of the barrier layer, i.e., on the side facing away from the substrate surface. This further layer may include AlOₓ, or an organic layer like Triacine or Acrylate.

Exemplary embodiments of systems and methods for processing a substrate are described above in detail. The systems and methods are not limited to the specific embodiments described in the specification, but rather, components of the systems and/or steps of the methods may be utilized independently and separately from other components and/or steps described in the specification. For example, modifying a substrate surface by an electron beam, prior to a coating step, may be carried out in systems differing from those described, for instance systems having no dedicated processing drum, and are not limited to the combinations described in the specification. The scope is defined by the claims.

Although specific features of various embodiments of the invention may be shown in some drawings and not in others, this is for convenience only. In accordance with the principles of the claimed invention, any feature of a drawing may be referenced and/or claimed in combination with any feature of any other drawing.

This written description uses examples to disclose the invention, including the best mode, and also to enable any person skilled in the art to practice the invention, including making and using any devices or systems and performing any incorporated methods. While various specific embodiments have been disclosed in the foregoing specification, those skilled in the art will recognize that the claims allows for equally effective modifications. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A method (200) of processing a flexible substrate (110), comprising:
providing (202) a flexible substrate (110) having a polymerized surface (112);
emitting (204) an electron beam (120);
exposing (206) the polymerized surface (112) to the electron beam (120) by directing the electron beam onto the polymerized surface, and wherein the electron beam has an electron energy from 1 to 6 keV;
modifying (208) the polymerized surface (112) by the exposure to the electron beam (120); and
depositing (210) a barrier layer on the modified surface.

2. The method (200) according to claim 1, wherein the flexible substrate (110) is selected from the group consisting of: a polypropylene-containing substrate, a polyester substrate, a nylon substrate, an OPP substrate, and a CPP substrate.

3. The method (200) according to any of claims 1 to 2, wherein the modifying (208) comprises cleaning of the surface (112), particularly removing water vapor from the surface.

4. The method (200) according to any of claims 1 to 3, wherein the modifying (208) comprises reducing the surface roughness of the surface (112).

5. The method (200) according to any of claims 1 to 4, wherein the modifying (208) comprises breaking up chemical bonds of the polymerized surface (112) of the substrate (110).

6. The method (200) according to any of claims 1 to 5, wherein the electron beam (120) is emitted with a beam current from 20 to 1500 mA.

7. The method (200) according to any of claims 1 to 6, further comprising:
inserting a processing gas;
exciting the processing gas with the emitted electron beam (120); and
exposing the substrate surface (112) to the excited processing gas.

8. The method (200) according to claim 7, wherein the processing gas is selected from the group consisting of: argon, more particularly nitrogen or oxygen, a mixture of nitrogen and oxygen, and combinations of the former.

9. The method (200) according to any of claims 1 to 8, further comprising:
spooling the flexible substrate from a roll; and
spooling the flexible substrate onto a roll.

10. The method (200) according to any of claims 1 to 9, wherein the barrier layer comprises at least one element from the group consisting of: aluminum, aluminum oxide, aluminum nitride, silicon, silicon oxide.

11. The method (200) according to any of claims 1 to 10, wherein the barrier layer is an optically transparent barrier for oxygen and/or water-vapor, particularly for oxygen and water-vapor.

12. The method (200) according to any of claims 1 to 11, further comprising:
depositing a AlOₓ or an organic layer like Triacine or Acrylate layer between the flexible substrate (110) and the barrier layer; and/or
depositing a AlOₓ or an organic layer like Triacine or Acrylate layer onto the barrier layer.

13. The method (200) according to any preceding claim, wherein the polymerized substrate surface (112) is irreversibly modified by the electron beam (120).

14. The method (200) according to any preceding claim, wherein the flexible substrate (110) comprises
PET, the deposited barrier layer comprises Al, the electron energy is 5 keV, and the electron current is 500mA.

## Patentansprüche

1. Verfahren (200) zur Verarbeitung eines flexiblen Substrats (110), umfassend:
Bereitstellen (202) eines flexiblen Substrats (110) mit einer polymerisierten Oberfläche (112);
Emittieren (204) eines Elektronenstrahls (120);
Aussetzen (206) der polymerisierten Oberfläche (112) gegenüber dem Elektronenstrahl (120) durch Richten des Elektronenstrahls auf die polymerisierte Oberfläche, und wobei der Elektronenstrahl eine Elektronenenergie von 1 bis 6 keV aufweist;
Modifizieren (208) der polymerisierten Oberfläche (112) durch das Aussetzen gegenüber dem Elektronenstrahl (120); und
Abscheiden (210) einer Barriereschicht auf der modifizierten Oberfläche.

2. Verfahren (200) nach Anspruch 1, wobei das flexible Substrat (110) aus der aus einem Polypropylen-haltigen Substrat, einem Polyestersubstrat, einem Nylonsubstrat, einem OPP-Substrat und einem CPP-Substrat bestehenden Gruppe ausgewählt ist.

3. Verfahren (200) nach einem der Ansprüche 1 bis 2, wobei das Modifizieren (208) das Reinigen der Oberfläche (112), insbesondere das Entfernen von Wasserdampf von der Oberfläche umfasst.

4. Verfahren (200) nach einem der Ansprüche 1 bis 3, wobei das Modifizieren (208) das Verringern der Oberflächenrauheit der Oberfläche (112) umfasst.

5. Verfahren (200) nach einem der Ansprüche 1 bis 4, wobei das Modifizieren (208) das Trennen chemischer Bindungen der polymerisierten Oberfläche (112) des Substrats (110) umfasst.

6. Verfahren (200) nach einem der Ansprüche 1 bis 5, wobei der Elektronenstrahl (120) mit einem Strahlstrom von 20 bis 1500 mA emittiert wird.

7. Verfahren (200) nach einem der Ansprüche 1 bis 6, ferner umfassend:
Einbringen eines Verarbeitungsgases;
Anregen des Verarbeitungsgases mit dem emittierten Elektronenstrahl (120); und
Aussetzen der Substratoberfläche (112) gegenüber dem angeregten Verarbeitungsgas.

8. Verfahren (200) nach Anspruch 7, wobei das Verarbeitungsgas aus der aus Argon, im Speziellen Stickstoff oder Sauerstoff, einem Gemisch aus Stickstoff und Sauerstoff sowie Kombinationen davon bestehenden Gruppe ausgewählt ist.

9. Verfahren (200) nach einem der Ansprüche 1 bis 8, ferner umfassend:
Abspulen des flexiblen Substrats von einer Rolle; und
Aufspulen des flexiblen Substrats auf eine Rolle.

10. Verfahren (200) nach einem der Ansprüche 1 bis 9, wobei die Barriereschicht zumindest ein Element aus der aus Aluminium, Aluminiumoxid, Aluminiumnitrid, Silicium und Siliciumoxid bestehenden Gruppe umfasst.

11. Verfahren (200) nach einem der Ansprüche 1 bis 10, wobei die Barriereschicht eine optisch transparente Barriere für Sauerstoff und/oder Wasserdampf, insbesondere für Sauerstoff und Wasserdampf, ist.

12. Verfahren (200) nach einem der Ansprüche 1 bis 11, ferner umfassend:
Abscheiden einer AlOₓ- oder organischen Schicht wie einer Triazin- oder Acrylatschicht zwischen dem flexiblen Substrat (110) und der Barriereschicht; und/oder
Abscheiden einer AlOₓ- oder organischen Schicht wie einer Triazin- oder Acrylatschicht auf der Barriereschicht.

13. Verfahren (200) nach einem der vorhergehenden Ansprüche, wobei die polymerisierte Substratoberfläche (112) durch den Elektronenstrahl (120) irreversibel modifiziert wird.

14. Verfahren (200) nach einem der vorhergehenden Ansprüche, wobei das flexible Substrat (110) PET umfasst, die abgeschiedene Barriereschicht Al umfasst, die Elektronenenergie 5 keV beträgt und der Elektronenstrom 500 mA beträgt.

## Revendications

1. Procédé (200) de traitement d'un substrat flexible (110), comprenant :
l'obtention (202) d'un substrat flexible (110) comportant une surface polymérisée (112) ;
l'émission (204) d'un faisceau d'électrons (120) ;
l'exposition (206) de la surface polymérisée (112) au faisceau d'électrons (120) en dirigeant le faisceau d'électrons sur la surface polymérisée, et dans lequel le faisceau d'électrons comporte une énergie électronique comprise entre 1 et 6 keV ;
la modification (208) de la surface polymérisée (112) par l'exposition au faisceau d'électrons (120) ; et
le dépôt (210) d'une couche de barrière sur la surface modifiée.

2. Procédé (200) selon la revendication 1, dans lequel le substrat flexible (110) est choisi dans le groupe constitué de : un substrat contenant du polypropylène, un substrat polyester, un substrat de nylon, un substrat OPP est un substrat CPP.

3. Procédé (200) selon la revendication 1 ou la revendication 2, dans lequel la modification (208) comprend le nettoyage de la surface (112), en particulier l'élimination de vapeur d'eau de la surface.

4. Procédé (200) selon l'une quelconque des revendications 1 à 3, dans lequel la modification (208) comprend la réduction de la rugosité surfacique de la surface (112).

5. Procédé (200) selon l'une quelconque des revendications 1 à 4, dans lequel la modification (208) comprend la cassure des liaisons chimiques de la surface polymérisée (112) du substrat (110).

6. Procédé (200) selon l'une quelconque des revendications 1 à 5, dans lequel le faisceau d'électrons (120) est émis avec un courant de faisceau compris entre 20 et 1500 mA.

7. Procédé (200) selon l'une quelconque des revendications 1 à 6, comprenant en outre :
l'insertion d'un gaz de traitement ;
l'excitation du gaz de traitement avec le faisceau d'électrons émis (120) ; et
l'exposition de la surface de substrat (112) au gaz de traitement excité.

8. Procédé (200) selon la revendication 7, dans lequel le gaz de traitement est choisi dans le groupe constitué de : l'argon, plus particulièrement de l'azote ou de l'oxygène, d'un mélange d'azote et d'oxygène, et de combinaisons de ce dernier.

9. Procédé (200) selon l'une quelconque des revendications 1 à 8, comprenant en outre :
le bobinage du substrat flexible à partir d'un rouleau ; et
le bobinage du substrat flexible sur un rouleau.

10. Procédé (200) selon l'une quelconque des revendications 1 à 9, dans lequel la couche de barrière comprend au moins un élément choisi dans le groupe constitué de : l'aluminium, l'oxyde d'aluminium, le nitrure d'aluminium, le silicium, l'oxyde de silicium.

11. Procédé (200) selon l'une quelconque des revendications 1 à 10, dans lequel la couche de barrière est une barrière optiquement transparente à l'oxygène et/ou à la vapeur d'eau, en particulier à l'oxygène et à la vapeur d'eau.

12. Procédé (200) selon l'une quelconque des revendications 1 à 11, comprenant en outre :
le dépôt d'un AlOₓ ou d'une couche organique de type Triacine ou d'une couche d'acrylate située entre le substrat flexible (110) et la couche de barrière ; et/ou
le dépôt d'un AlOₓ ou d'une couche organique de type Triacine ou d'une couche d'acrylate sur la couche de barrière.

13. Procédé (200) selon l'une quelconque des revendications précédentes, dans lequel la surface de substrat polymérisé (112) est modifiée de manière irréversible par le faisceau d'électrons (120).

14. Procédé (200) selon l'une quelconque des revendications précédentes, dans lequel le substrat flexible (110) comprend du PET, la couche de barrière déposée comprend de l'Al, l'énergie électronique est de 5 keV et le courant électronique est de 500 mA.
